Europäisches Patentamt

European Patent Office

Office européen des brevets

(19)

(11) **EP 0 511 139 B1**

(12) **FASCICULE DE BREVET EUROPEEN**

(45) Date de publication et mention
de la délivrance du brevet:
**24.07.1996 Bulletin 1996/30**

(51) Int Cl.⁶: **H03M 13/12**

(21) Numéro de dépôt: **92460011.7**

(22) Date de dépôt: **22.04.1992**

(54) **Procédé de décodage d'un code convolutif à maximum de vraisemblance et pondération des décisions, et décodeur correspondant**

Dekodierungsverfahren für Maximalwahrscheinlichkeitsfaltungskoder, und Bewertung der Entscheidungen, und Dekoder dafür

Decoding process for a maximum likelihood convolutional code and weighting of the decisions, and decoder therefor

(84) Etats contractants désignés:
**DE GB**

(30) Priorité: **23.04.1991 FR 9105279**

(43) Date de publication de la demande:
**28.10.1992 Bulletin 1992/44**

(73) Titulaires:
• **FRANCE TELECOM**
**75015 Paris (FR)**
• **TELEDIFFUSION DE FRANCE**
**F-75932 Paris Cédex 15 (FR)**

(72) Inventeurs:
• **Berrou, Claude**
**F-29217 Le Conquet (FR)**
• **Adde, Patrick**
**F-29200 Brest (FR)**

(74) Mandataire: **Corlau, Vincent**
**c/o Cabinet Vidon,**
**Immeuble Germanium,**
**80 avenue des Buttes de Coesmes**
**35700 Rennes (FR)**

(56) Documents cités:
**EP-A- 0 210 932**

• **THE TRANSACTION OF THE INSTITUTE OF ELECTRONICS, INFORMATION AND COMM. ENGINEERS vol. E72, no. 5, Mai 1989, TOKYO, JP pages 485 - 492; TAJIMA ET AL: 'SST VITERBI DECODER BRANCH METRIC COMPUTATION BASED ON MAP ESTIMATION METHOD'**
• **PROCEEDINGS OF THE EUSIPCO-88 5 Septembre 1988, GRENOBLE, FR pages 339 - 342; FETTWEIS ET AL: 'A MODULAR VARIABLE SPEED VITERBI DECODING IMPLEMENTATION FOR HIGH DATA RATES'**
• **ANNALES DES TELECOMMUNICATIONS vol. 31, no. 11, Novembre 1976, PARIS, FR pages 387 - 404; BATTAIL ET AL: 'DECODAGE PAR REPLIQUES'**

**Description**

Le domaine de l'invention est celui du décodage de données numériques reçues dans un décodeur, et notamment de données transmises en présence de bruit de transmission.

Plus précisément, le procédé de l'invention concerne le décodage de données obtenues selon un codage convolutif. De façon connue, les codes convolutifs associent à une donnée source à transmettre au moins une valeur codée obtenue par combinaison linéaire de cette donnée source avec au moins une des données source précédentes.

Classiquement, de tels codes sont décodés à l'aide d'un algorithme à maximum de vraisemblance, du type de l'algorithme de Viterbi. Cet algorithme fournit une estimation binaire de chaque symbole codé à l'émission. Cette estimation s'avère donc, selon le succès du décodage, ou totalement bonne, ou totalement mauvaise.

Il est apparu qu'il est particulièrement intéressant de pondérer les décisions prises par un algorithme de décision à maximum de vraisemblance, notamment lorsque le code convolutif mis en oeuvre est concaténé avec un ou plusieurs autres codes, tels que par exemple un autre code de type convolutif. En effet, cela permet alors d'informer le décodeur de ce code concaténé de la fiabilité de l'estimation qui lui est transmise.

Un décodeur à décisions pondérées délivre donc en sortie une information codée sur n bits, le bit de poids fort étant identique à celui délivré par le décodeur classique et les n - 1 bits restants représentant la fiabilité affectée à la décision.

On sait que l'algorithme de Viterbi, qui sera décrit plus en détail par la suite, repose sur la détermination d'un chemin optimal dans un treillis, par l'élimination systématique d'un chemin parmi deux chemins possibles atteignant chaque noeud du treillis. Pour chaque noeud, on détermine donc deux métriques de transition, représentatives de la distance entre la transition possible sur chaque chemin et la valeur effectivement reçue par le décodeur. Ces métriques de transition permettent de calculer des métriques cumulées, représentatives du bruit cumulé sur le chemin considéré. Une métrique cumulée est ainsi une intégrale des métriques de transition. Selon l'algorithme de Viterbi, seul le chemin correspondant à la métrique cumulée la plus faible est conservé.

Il apparaît clairement que l'élimination systématique d'un chemin introduit un risque d'erreur, notamment lorsque les deux métriques calculées sont proches. En revanche, lorsque l'une des métriques est faible et l'autre élevée, la probabilité d'erreur d'estimation est faible. La première idée mise en oeuvre pour pondérer l'algorithme de Viterbi a donc été d'associer, à chaque noeud, un coefficient de pondération égal à la différence (en valeur absolue) entre les deux métriques cumulées.

Ce mode de pondération, particulièrement simple, n'est pas optimal, en termes de résultat.

On connaît par ailleurs, par le document de brevet français FR-85 11863, déposé le 02.08.1985 au nom de Battail, un procédé amélioré de décodage à pondération des symboles décodés par l'algorithme de Viterbi. Selon ce procédé, le coefficient de pondération associé à une décision est révisé périodiquement en tenant compte des échantillons reçus ultérieurement.

Ce procédé donne des résultats beaucoup plus satisfaisants que le principe de base. En revanche, il s'avère extrêmement complexe à mettre en oeuvre. En effet, il impose la mémorisation permanente des deux chemins associés à chaque noeud, ainsi qu'un nombre élevé de calculs à chaque instant de réception. En pratique, ce procédé ne peut pas être implanté sur un circuit intégré pour être diffusé industriellement à un coût raisonnable.

L'invention a notamment pour objectif de pallier ces différents inconvénients de l'état de la technique.

Plus précisément, l'invention a pour objectif de fournir un procédé de décodage de code convolutif à maximum de vraisemblance et pondération des décisions, dont les résultats sont quasi-optimaux, et en particulier supérieurs à ceux des procédés déjà connus, ou tout au moins équivalents, pour une complexité moindre. Un objectif essentiel de l'invention est donc, en d'autres termes, de fournir un tel procédé assurant une répartition statistique de la pondération quasiment gaussienne.

L'invention a également pour objectif de fournir un tel procédé, limitant la complexité de mise en oeuvre, tant en ce qui concerne les moyens de stockage que les moyens de traitement nécessaires. Un objectif particulier de l'invention est ainsi de fournir un tel procédé de décodage, qui soit aisément implantable sur silicium, et donc réalisable à faible coût industriellement.

Un autre objectif de l'invention est de fournir un tel procédé compatible avec tous les types de codes convolutifs, binaires ou plus généralement n-aires, quels que soient leur rendement (égal à 1/R, R entier > 1) et leur longueur de contrainte, qu'ils soient ou non poinçonnés. Notamment, l'invention a pour objectif de fournir un tel procédé permettant le décodage de données codées selon le procédé décrit dans la demande de brevet FR 91 05278, déposée le 23 avril 1991 aux noms des mêmes déposants, intitulée "procédé de codage convolutif correcteur d'erreurs pseudo-systématique, procédé de décodage et dispositifs correspondants".

De même, l'invention a pour objectif de fournir un tel procédé, qui puisse être mis en oeuvre conjointement avec un ou plusieurs autres décodeurs concaténés.

L'invention a également pour objectif de fournir un décodeur utilisant un tel procédé de décodage.

Ces objectifs, ainsi que d'autres qui apparaîtront par la suite, sont atteints selon l'invention à l'aide d'un procédé de décodage à maximum de vraisemblance d'une séquence d'échantillons reçus R(t), correspondant au codage convolutif d'une séquence d'éléments numériques source a(t), du type associant à chacun desdits échantillons reçus R(t) une estimation s(t) de l'élément numérique source correspondant a(t) et un coefficient de pondération m(t) représentatif de la fiabilité de ladite estimation s(t), ladite estimation s(t) prenant en compte les valeurs d'une première série de L échantillons reçus, comprenant ledit échantillon reçu R(t) correspondant audit élément numérique source a(t) et les L-1 échantillons reçus suivants R(t+1),..., R(t+L-1), L étant supérieur ou égal à 2, et ladite pondération m(t) prenant en compte les valeurs d'une seconde série de N échantillons reçus, comprenant ledit échantillon reçu R(t) correspondant audit élément numérique source a(t) et les N-1 échantillons reçus suivants R(t+1),..., R(t+L-1),..., R(t+N-1), N étant strictement supérieur à L.

Il s'avère en effet particulièrement efficace, après avoir décidé de l'estimation d'une valeur, de suivre encore l'évolution des échantillons reçus pour lui affecter un coefficient de pondération.

Dans le cas d'un procédé de décodage du type comprenant une étape d'estimation de la valeur s(t) de chacun desdits éléments numériques source a(t), prenant en compte, pour l'estimation de la valeur d'un élément numérique source s(t), les valeurs d'une série d'échantillons reçus, comprenant l'échantillon reçu R(t) correspondant audit élément numérique source a(t) et au moins un des échantillons reçus suivants R(t+1),..., R(t+L-1), et une étape de pondération de l'estimation s(t) consistant à associer, à chacune desdites estimations s(t), un coefficient de pondération m(t) représentatif de la fiabilité de ladite estimation, ce procédé comprend avantageusement également une étape de révision dudit coefficient de pondération consistant à réviser, à chaque instant de réception t, chacun des coefficients de pondération m(t-N) à m(t-L-1), correspondant aux N-L dernières valeurs estimées s(t-N) à s(t-L-1), en fonction de l'échantillon reçu R(t).

L'invention concerne notamment un procédé du type consistant à décider, à l'aide d'un algorithme décisionnel du type de l'algorithme de Viterbi, d'une estimation s(t) de la valeur de chacun desdits éléments numériques source a(t), ledit algorithme décisionnel définissant un premier treillis $T(2^\nu, L)$ des états possibles du codage, comprenant un ensemble de noeuds, organisé en L colonnes, ou niveaux de profondeur, de $2^\nu$ noeuds, L étant le nombre d'échantillons reçus R(t-L-1),..., R(t) pris en compte pour l'estimation s(t) de la valeur d'un desdits éléments numériques source a(t), et $2^\nu$ étant le nombre d'états possibles du code convolutif à un instant donné, $\nu$ étant la longueur de contrainte du code utilisé, chacun desdits noeuds d'un niveau de profondeur i donné correspondant à un instant de réception donné, et étant relié à deux noeuds du niveau de profondeur précédenti-1, correspondant à l'instant de réception précédent, par l'intermédiaire de deux chemins, chaque chemin correspondant à une transition possible selon ledit code convolutif, ladite étape d'estimation consistant à :

- déterminer, pour chaque noeud dudit premier treillis, le chemin y aboutissant le plus probable, ou chemin survivant, et éliminer dudit premier treillis le chemin concurrent dudit chemin survivant, le chemin survivant étant celui présentant la distance cumulée, ou métrique cumulée, $M^0$ ou $M^1$ la plus faible ;

- remonter dans ledit premier treillis le chemin optimal, en partant du noeud présentant la métrique cumulée la plus faible sur le premier niveau de profondeur, correspondant au dernier échantillon R(t) reçu, et en suivant à chaque niveau le chemin survivant associé au noeud atteint,

- associer à l'estimation s(t-L) correspondant au décodage de l'échantillon reçu R(t-L), la valeur du noeud terminal dudit chemin optimal,

et ladite étape de pondération consistant à associer à ladite estimation s(t-L) un coefficient de pondération m(t-L), représentatif de la fiabilité de ladite estimation s(t-L), ledit coefficient de pondération étant obtenu par analyse des métriques cumulées $M^0$ et $M^1$ associées à chacun des noeuds dudit chemin optimal,

ledit procédé étant caractérisé en ce qu'il comprend une étape de révision desdits coefficients de pondération, consistant à, à chaque instant de réception t :

- mémoriser le coefficient de pondération m(t-L) associé à ladite estimation s(t-L);

- définir un second treillis $T'(2^\nu, L')$ des états possibles du codage, où L'=N-L, consécutif audit premier treillis $T(2^\nu, L)$, correspondant aux instants de réception compris entre t-L-1 et t-L-L';

- remonter, dans ledit second treillis, les deux chemins concurrents correspondant aux deux chemins issus dudit noeud terminal du chemin optimal du premier treillis ;

- réviser les valeurs de chacun des coefficients de pondération m(t-L-1) à m(t-N) associé respectivement à chacune des estimations s(t-L-1) à s(t-N) des valeurs des échantillons numériques reçus entre les instants t-L-1 et t-N, en fonction d'une comparaison niveau à niveau des valeurs $s_k$ et $s'_k$ correspondant à ces échantillons numériques reçus, sur les deux chemins concurrents.

Dans un mode de réalisation préférentiel de l'invention, ledit coefficient m(t-L) déterminé lors de ladite étape de pondération est égal à la valeur absolue $\Delta M_{t-L}$ de la différence entre les deux métriques $M^0_{t-L}$ et $M^1_{t-L}$ associées audit noeud terminal dudit chemin optimal, encore appelée indice de concurrence, lesdites métriques

$M^0_{t-L}$ et $M^1_{t-L}$ étant le cumul des distances $L^0$ ou $L^1$ calculées pour chaque noeud dudit chemin optimal, lesdites distances représentant l'écart entre le symbole reçu et les symboles correspondant aux deux transitions possibles pour atteindre ce noeud.

En effet, la valeur absolue de l'écart entre ces deux métriques est directement représentative de la confiance que l'on peut accorder à une estimation. Si les deux métriques sont proches, la décision sera peu fiable. Au contraire, si l'une des métriques est élevée et l'autre faible, il est probable que le symbole reçu corresponde effectivement à la métrique faible.

Avantageusement, ladite étape de révision réalise, à chaque instant de réception t et pour chacun des niveaux k dudit second treillis, une comparaison des valeurs $s_k$ et $s'_k$ correspondant à l'échantillon reçu R(t-L-k) sur chacun des deux chemins concurrents, ledit indice de concurrence $m_k$ étant révisé à la baisse si ces valeurs $s_k$ et $s'_k$ sont différentes.

Il est important en effet que la confiance accordée à une estimation donnée ne soit pas supérieure à la confiance accordée au choix du chemin permettant d'y parvenir.

Dans un mode de réalisation particulier de l'invention, lorsque lesdites valeurs $s_k$ et $s'_k$ correspondant à l'échantillon reçu R(t-L-K) sur chacun des deux chemins concurrents sont différentes, ledit indice de concurrence $m_k$ est pris égal à la plus petite des valeurs $m_k$ et $m_L$, $m_L$ étant l'indice de concurrence associé à l'estimation s(t-L), origine desdits chemins concurrents, déterminé lors de ladite étape de pondération.

De façon avantageuse, un coefficient de pondération provisoire $\Delta M$ est associé à chacun desdits noeuds dudit premier treillis, chacun desdits coefficients de pondération $\Delta M$ étant mis à jour à chaque instant de réception t, en fonction de l'échantillon reçu R(t).

Dans une autre variante de l'invention, ledit indice de concurrence $m_L$ est recalculé, à chaque instant de réception t, en fonction des échantillons reçus mémorisés R(t - L) à R(t).

Préférentiellement, ladite étape de révision comprend une étape de compression logarithmique dudit indice de concurrence $m_{t-L}$, avant de le mémoriser.

Cette caractéristique, qui a pour but d'obtenir un meilleur échantillonnage des valeurs critiques vis à vis de la décision, permet d'obtenir une réduction importante des taux d'erreur.

Dans un mode de réalisation avantageux, la profondeur L'dudit second treillis est sensiblement égale à la moitié de la profondeur L dudit premier treillis.

Il ne faut pas, en effet, que la longueur L'soit trop importante. Dans le cas contraire, il apparaît des problèmes de révision inopportune à la baisse, lorsque les deux chemins concurrents sont faux.

Les échantillons reçus R(t) peuvent notamment être du type comprenant, à au moins certains instants t, deux données codées distinctes X(t) et Y(t) correspondant audit élément numérique source a(t).

Il peut en particulier s'agir de données produites par des codes convolutifs classiques, séparables, systématiques, ou tels que décrits dans la demande de brevet conjointe déjà citée.

L'invention concerne également un décodeur mettant en oeuvre le procédé décrit ci-dessus, et notamment un décodeur d'une séquence d'échantillons reçus R(t), correspondant au codage convolutif d'une séquence d'éléments numériques source a(t), comprenant :

- des moyens de mémorisation desdits premier et second treillis, se comportant comme des registres à décalage niveau par niveau ;
- des moyens de remontée dudit chemin optimal, dans ledit premier treillis, et des moyens de remontée des deux chemins concurrents dans ledit second treillis;
- des moyens de mémorisation de l'ensemble desdits indices de concurrence associés à chacun des noeuds dudit premier treillis, de taille $L \times 2^v \times \mu$, $\mu$ étant le nombre de bits utilisés pour le codage d'un indice de concurrence ;
- un registre à décalage, pour la mémorisation des coefficients de pondération m(t-L-1) à m(t-N) ;
- des moyens de révision desdits coefficients de pondération, en fonction des deux chemins concurrents remontés dans ledit second treillis.

Dans un autre mode de réalisation, les moyens de mémorisation de l'ensemble desdits indices de concurrence associés à chacun des noeuds dudit premier treillis, peuvent être remplacés par des moyens de mémorisation de l'ensemble des échantillons reçus R(t-L) à R(t), de taille $L \times n$, n étant le nombre de bits utilisés pour le codage de la valeur d'un échantillon reçu.

Avantageusement, ledit registre à décalage pour la mémorisation des coefficients de pondération est alimenté par l'indice de concurrence $m_{t-L}$ dudit noeud final dudit chemin optimal, transformé selon une loi logarithmique.

D'autres caractéristiques et avantages apparaîtront à la lecture de la description d'un mode de réalisation préférentiel de l'invention, donné à titre illustratif, et des dessins annexés dans lesquels :

- la figure 1 est un schéma du codeur convolutif considéré dans le mode de réalisation décrit, correspondant au code dit "standard", ayant une longueur de contrainte $v$ égale à 2 et un rendement de 1/2 ;

- la figure 2 est un treillis des états du codage, représentatif du fonctionnement du codeur de la figure 1 ;
- la figure 3 est un treillis de décodage, mis en oeuvre dans un algorithme de Viterbi, de dimension horizontale, ou profondeur, L et de dimension verticale $2^\nu$;
- la figure 4 présente la structure complète d'un décodeur mettant en oeuvre le procédé de l'invention, comprenant notamment un premier et un second treillis;
- la figure 5 est un schéma synoptique d'un exemple de module de calcul des métriques et des chemins survivants associés, selon un procédé connu ;
- la figure 6 est un schéma synoptique d'un exemple particulier de réalisation d'un décodeur tel que représenté en figure 4 ;
- la figure 7 présente un schéma synoptique détaillé du module de remontée du chemin optimal du décodeur de la figure 6 ;
- la figure 8 présente un schéma synoptique détaillé du module de révision de la concurrence du décodeur de la figure 6 ;
- la figure 9 illustre une variante du calcul des coefficients de pondération, par rapport aux moyens mis en oeuvre dans le décodeur de la figure 6 ;
- la figure 10 présente une série de courbes illustrant les performances du procédé de l'invention, dans le cas d'un code de longueur de contrainte 4 et de rendement 4/7 concaténé à un code de longueur de contrainte 2 et de rendement 7/8, les deux décodeurs travaillant en décisions fines.

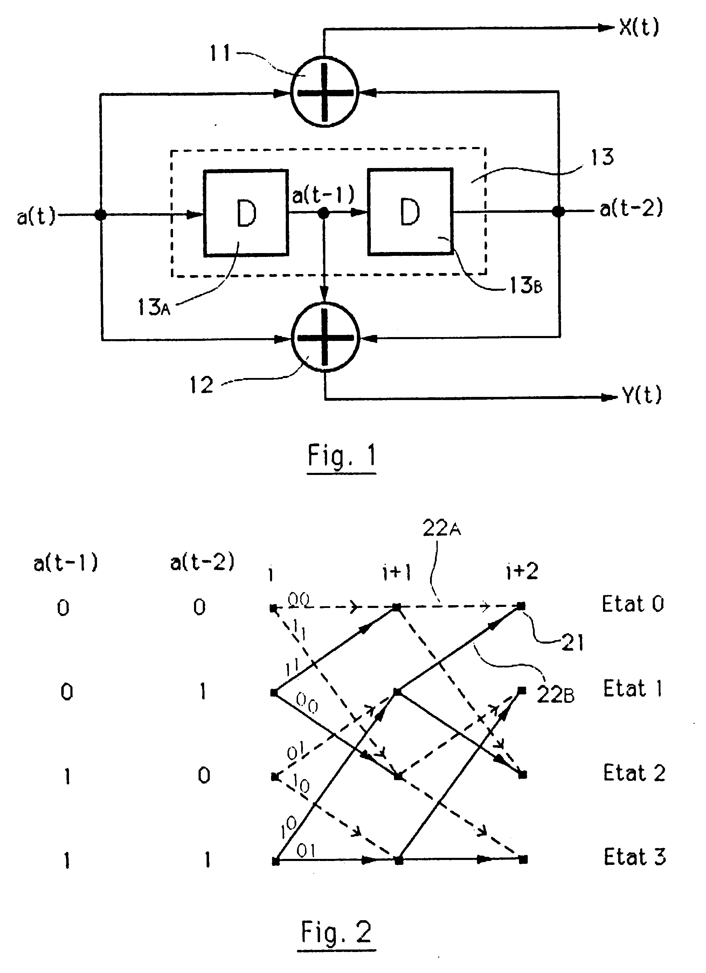

Le fonctionnement du procédé de l'invention est décrit ci-dessous en détail dans le cas d'un code convolutif standard, de longueur de contrainte $\nu$ =2 et de rendement 1/2, obtenu à l'aide d'un codeur tel que représenté en figure 1. Toutefois, il est clair que ce procédé de décodage peut s'appliquer à tous les codes convolutifs de rendement $\eta$ = 1/R (R entier > 1)quels qu'ils soient, par simple généralisation du procédé décrit.

La figure 1 présente donc un codeur standard, qui associe à chaque donnée source a(t) deux valeurs codées distinctes X(t) et Y(t), obtenues par les sommes modulo 2 (OU exclusif) 11 et 12 de cette donnée source a(t) avec l'une au moins des données source précédentes a(t-1), a(t-2) mémorisées dans les cellules $13_A$, $13_B$ d'un registre à décalage 13.

Le fonctionnement de ce codeur peut être décrit par le diagramme du treillis représenté en figure 2. Cette présentation a été proposée par G.D. Forney, dans l'article "The Viterbi algorithm" (Proc. IEEE, mars 1973, 61, n° 3, pp. 268 - 278).

L'algorithme de Viterbi est une technique de décodage qui permet de trouver dans le treillis le chemin à vraisemblance maximale, c'est-à-dire le chemin le plus probable par rapport à celui décrit à l'émission par le codeur.

Chaque noeud 21 du treillis utilisé lors du décodage contient une information sur le chemin survivant, parmi les chemins $22_A$ et $22_B$ aboutissant au noeud 21. Le principe de base de l'algorithme de Viterbi est en effet de ne considérer, en chaque noeud, que le chemin le plus probable, de façon à permettre de remonter aisément le treillis, et donc de déterminer, a posteriori, une estimation de la valeur reçue plusieurs instants de réception auparavant.

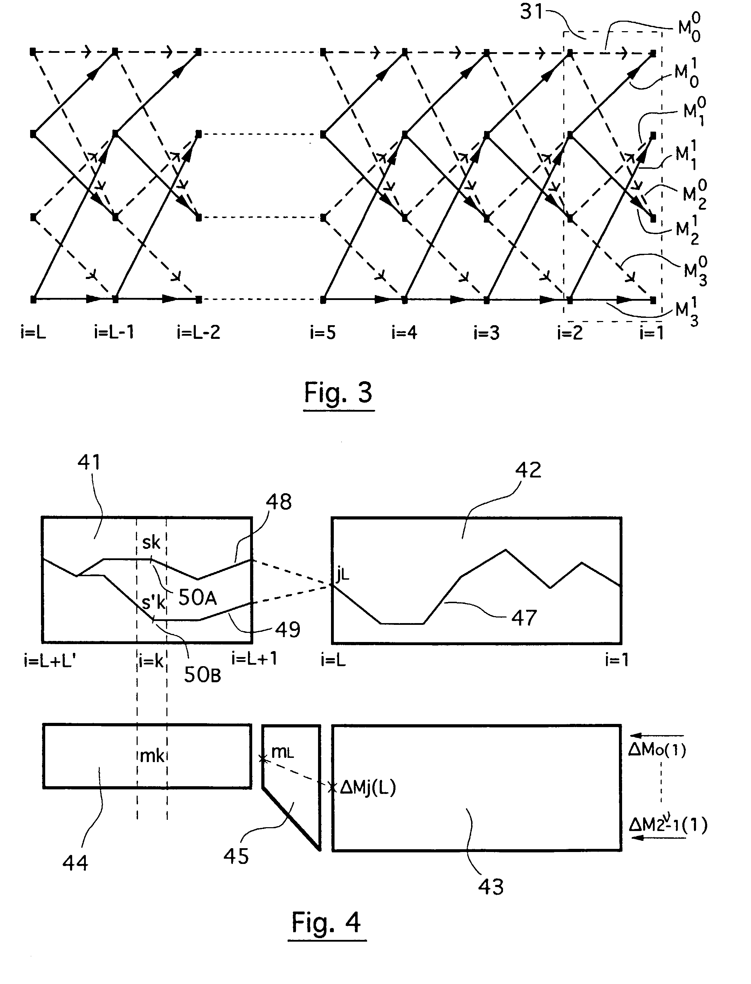

Le treillis utilisé au décodage, noté $T(2^\nu , L)$, est représenté en figure 3. Il a une dimension "verticale" égale au nombre d'états possibles du codeur, soit $2^\nu$, $\nu$ étant la longueur de contrainte du code, c'est-à-dire le nombre d'éléments mémoires utilisés lors du codage, et une dimension "horizontale", appelée profondeur, notée L. Dans le cas présent, $2^\nu$ est égal à 4.

Par ailleurs, il est clair que l'algorithme est d'autant plus efficace que L est grand, puisque L correspond au nombre d'échantillons reçus pris en compte pour le décodage d'un échantillon donné.

L'algorithme de Viterbi est notamment décrit dans l'article "Error bounds for convolutional codes and an asymptotically optimum decoding algorithm" (Viterbi A.J., IEEE Trans. IT, USA (nov. 1967), 13, n° 6, pp. 260 - 269). On rappelle ici, sur l'exemple du code standard, les opérations effectuées dans cet algorithme en une période d'horloge T :

1/ On calcule les distances, encore appelées métriques de transition ou métriques de branche, entre les symboles reçus et les symboles correspondant aux 8 transitions possibles 31, à savoir :

$$L^0_j = |X' - X^0_j| + |Y' - Y^0_j|$$

$$L^1_j = |X' - X^1_j| + |Y' - Y^1_j|$$

pour j variant de 0 à 3,
et où :

(X',Y') représente le couple effectivement reçu et échantillonné sur n bits ;
$X^0_j$ (respectivement $Y^0_j$) représente la valeur X (respectivement Y) considérée sur la transition aboutissant à l'état j et correspondant à une valeur a(t-2) quittant le registre du codeur égale à 0 (correspondant aux liaisons en pointillé sur la figure 3) ;

$X^1_j$ (respectivement $Y^1_j$ ) représente la valeur X (respectivement Y) considérée sur la transition aboutissant à l'état j et correspondant à une valeur a(t-2) quittant le registre du codeur égale à 1 (correspondant aux liaisons en trait plein sur la figure 3).

Dans le cas général, $2^{v+1}$ transitions sont ainsi calculées.

2/ A chaque état j est associé un additionneur-accumulateur contenant la métrique cumulée $M_j$ telle que:

$$M^0_0 (t) = M_0 (t-1) + L^0_0 (t-1); M^1_0 (t) = M_1 (t-1) + L^1_0 (t-1)$$

$$M^0_1 (t) = M_2 (t-1) + L^0_1 (t-1) ; M^1_1 (t) = M_3 (t-1) + L^1_1 (t-1)$$

$$M^0_2 (t) = M_0 (t-1) + L^0_2 (t-1) ; M^1_2 (t) = M_1 (t-1) + L^1_2 (t-1)$$

$$M^0_3 (t) = M_2 (t-1) + L^0_3 (t-1) ; M^1_3 (t) = M_3 (t-1) + L^1_3 (t-1)$$

$$M_j (t) = min (M^0_j (t); M^1_j (t))$$

3/ A chaque état j est associé un point mémoire, par exemple une bascule D, et l'ensemble du treillis constitue un registre de dimension (4, L). Sur la figure 3, le décalage a lieu de la droite vers la gauche. Au premier niveau (1=1), le contenu $s_j$ de la bascule associée à l'état j est mis à 0 si $M^0_j (t) \leq M^1_j (t)$, et à 1 si $M^0_j (t) > M^1_j (t)$. $S_j$ est donc directement représentatif du signe de $M^0_j (t) - M^1_j (t)$ ;

4/ On remonte le chemin mémorisé dans le treillis de i=1 à i=L en partant de l'état pourvu d'une métrique cumulée $M_j$ la plus faible, parmi 4, et en utilisant à chaque niveau de cette remontée le contenu de la bascule à laquelle on aboutit, pour choisir entre les deux transitions possibles. Le bit décodé provient alors de la bascule au niveau i=L, en fin de chemin remonté. Ainsi, à l'instant t, on décode le bit a(t-L) ;

5/ On effectue un décalage complet du treillis et on recommence à la période d'horloge suivante.

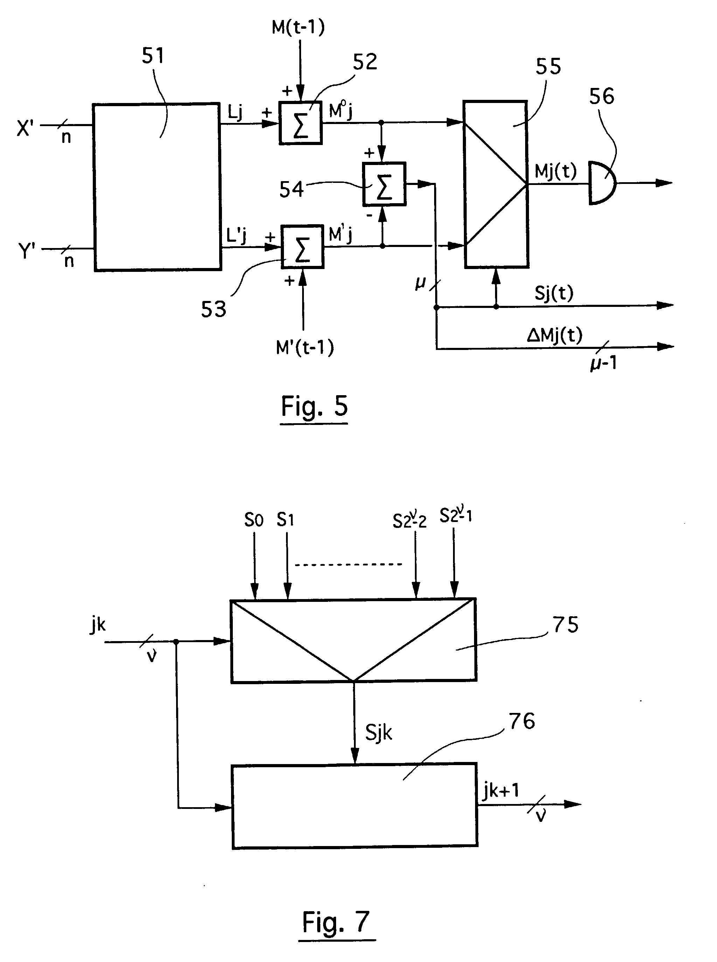

A titre d'exemple, on décrit ci-dessous un mode de réalisation d'un module de calcul des métriques et des chemins survivants associés, tel qu'il peut être mis en oeuvre dans un décodeur, en relation avec la figure 5.

Les données reçues X′ et Y′, échantillonnées sur n bits, sont introduites dans un module 51 de calcul des distances, selon le principe décrit plus haut (étape 1), produisant en sortie les valeurs $L^0_j$ et $L^1_j$.

Deux sommateurs 52 et 53 déterminent les métriques cumulées :

$$M^0_j = M(t-1) + L^0_j$$

$$M^1_j = M'(t-1) + L^1_j$$

Les valeurs M(t-1) et M′(t-1) ne sont pas indicées : elles dépendent du treillis considéré, et donc du code utilisé. Par exemple, si l'on considère le treillis de codage de la figure 2, ces valeurs sont obtenues de la façon décrite à l'étape 2 ci-dessus.

Un soustracteur 54 détermine ensuite la différence entre les deux métriques cumulées $M^0_j$ et $M^1_j$, codée sur μ bits. Cette différence peut se décomposer entre le signe $s_j(t)$ de la différence et la valeur absolue $\Delta M_j(t)$ de cette différence, qui correspond à une pondération de la décision sur le signe.

Le signe $s_j(t)$ désigne la métrique cumulée la plus faible. Il pilote donc un multiplexeur 2 vers 1 55, qui dirige la métrique concernée $M_j(t)$ vers les bascules 56.

Selon l'invention, un coefficient de pondération est associé à chacun des bits décodés, puis révisé au moins une fois. Pour cela, dans le mode de réalisation décrit, et ainsi que cela est représenté en figure 4, le premier treillis $T(2^v , L)$ 42 est complété sur sa gauche, c'est-à-dire après le niveau i=L, par un second treillis $T'(2^v, L')$ 41.

En parallèle avec le premier treillis 42 est disposée une mémoire 43 de type FIFO ("First In - First Out" ; "premier entré - premier sorti"), de taille $L \times 2^v \times \mu$. Cette mémoire 43 est alimentée, à chaque période d'horloge, par les $2^v$ grandeurs:

$$\Delta M_j (t) = |M^0_j (t) - M^1_j (t)|$$

pour j variant de 0 à $2^v - 1$, $\Delta M_j (t)$ étant codé sur μ bits.

On appellera par la suite $\Delta M_j (t)$ "indice de concurrence", "mesure de concurrence", ou "concurrence".

En parallèle avec le second treillis 41 est disposé un registre à décalage 44, de taille $L' \times (n-1)$. Ce registre 44 est alimenté par la concurrence issue de la mémoire FIFO 43 au niveau i=L, à l'adresse correspondant à l'état $j_L$ auquel la remontée du chemin optimal 47 du premier treillis 42 a abouti.

Avantageusement, cette concurrence est modifiée avant d'être mémorisée dans le registre 44, selon une loi de compression logarithmique 45, de la forme $\log(1 + x/\theta)$. De très bons résultats sont notamment atteints avec $\theta=1/d$, où d est la distance libre du code.

Soient $m_L$ cette concurrence modifiée par la compression logarithmique 45, et $m_k$ le contenu du registre 44 au niveau k (k>L), $m_L$ et $m_k$ étant codées sur n-1 bits. Soit également $s_L$ la valeur binaire contenue dans la bascule d'adresse i=L, $j=j_L \cdot s_L$ est le signe associé à $m_L$.

La caractéristique essentielle de l'invention est de poursuivre (48) dans le second treillis 41 la remontée 47 du chemin à vraisemblance maximale du premier treillis 42, et de remonter, dans le même temps, également dans le second treillis 41, le chemin concurrent 49 du chemin à vraisemblance maximale 48. Ce chemin concurrent 49 est l'autre chemin quittant l'état $j_L$, c'est-à-dire le chemin donné par le signe $\bar{s}_L$. Soient $s_k$ et $s'_k$ les contenus des deux bascules $50_A$ et $50_B$, au niveau k, des deux chemins ainsi remontés simultanément.

Une opération de révision du contenu du registre 44 est alors effectuée, sous la forme suivante, pour tout niveau k :

$$\text{si } s_k \neq s'_k \text{ et si } m_k > m_L, \text{ alors } m_k = m_L$$

Le résultat final du décodage est donné, après une latence L + L′, sous la forme suivante :

- pour le signe (valeur binaire estimée), par $s_{L + L'}$;
- pour le poids, ou coefficient de pondération, par $m_{L + L'}$.

La profondeur L′ du second treillis 41 est choisie de façon à obtenir les résultats les plus efficaces. Il apparaît ainsi que la longueur L'idéale est de l'ordre de L/2, L étant la profondeur du premier treillis 42. On constate notamment que, lorsque L' est plus élevée, les résultats se dégradent, en particulier du fait de révisions inopportunes lorsque les deux chemins concurrents 48 et 49 sont faux.

On présente maintenant un exemple de mise en oeuvre dans un décodeur du procédé qui vient d'être décrit.

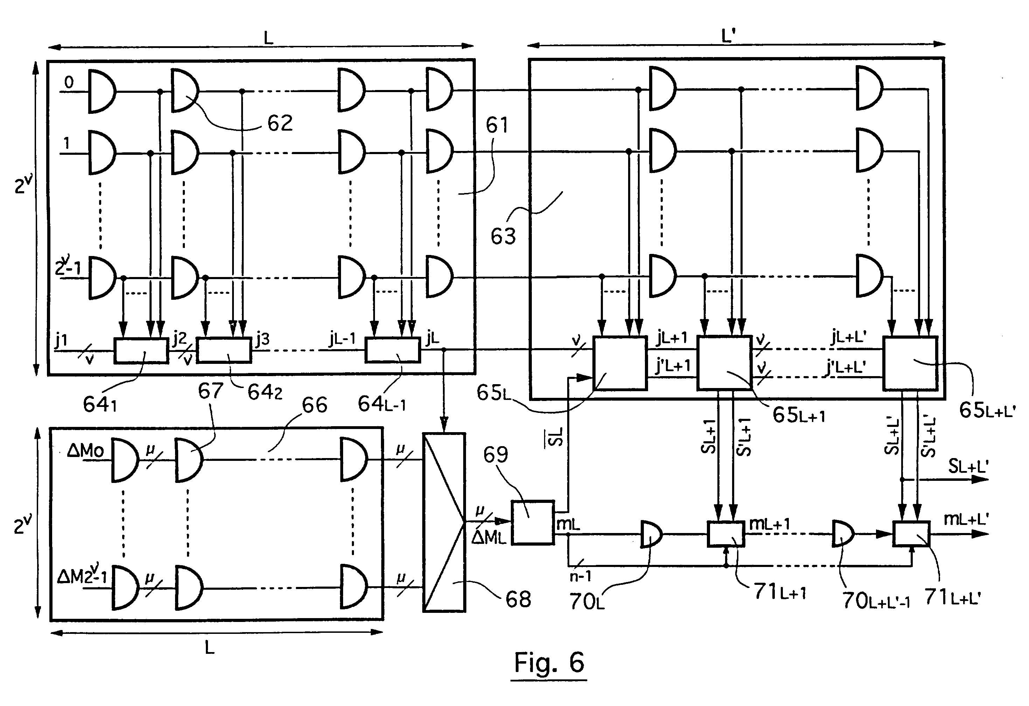

La figure 6 est un schéma synoptique d'un tel décodeur. Il comprend un premier treillis 61, constitué de L x $2^v$ bascules D 62 placées en $2^v$ lignes de L bascules cascadées. Ce premier treillis se prolonge directement par un second treillis similaire 63, de profondeur L′.

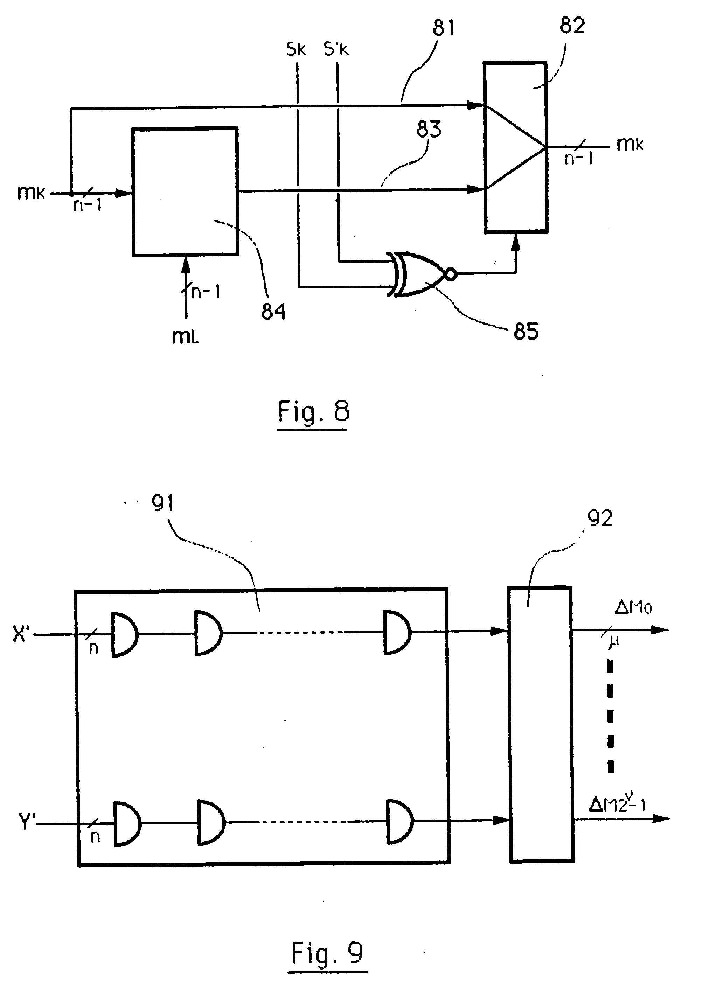

A chaque niveau de profondeur (colonne) du treillis 61 correspond un module $64_1$ à $64_{L-1}$ de remontée, déterminant le chemin optimal. Le fonctionnement de ce module 64 est précisé plus loin, en liaison avec la figure 7.

De même, un module $65_L$ à $65_{L+L}$, de double remontée est associé à chaque niveau du second treillis 63. Il détermine les deux chemins concurrents utilisés pour réviser les coefficients de pondération $m_L$ à $m_{L+L'}$. Ces modules à double remontée 65 sont constitués de deux modules de remontée simple, tels que décrits en figure 7, placés en parallèle.

Parallèlement au treillis 61, le décodeur comprend une mémoire FIFO 66, dont chaque bascule 67 mémorise la concurrence ΔM correspondant à chaque noeud du treillis 61, codée sur μ bits.

La mémoire 66 est connectée à un multiplexeur $2^v$ vers 1 68, piloté par la valeur $j_L$ issue du dernier module $64_{L-1}$ de remontée, qui désigne l'extrémité du chemin optimal. Ce multiplexeur 68 délivre donc la valeur de la métrique cumulée $\Delta M_L$ qui est transformée par un module 69 de compression logarithmique.

Le module 69 de compression logarithmique fournit d'une part la valeur $\bar{s}_L$ opposée au signe de $M^0_j(t) - M^1_j(t)$, qui indique l'origine du chemin concurrent du chemin optimal, et qui est transmise au premier module $65_L$ de double remontée, et d'autre part un coefficient de pondération, ou indice de concurrence, $m_L$.

Ce module 69 de compression logarithmique a pour but de mettre l'accent, en terme de qualité d'échantillonnage, sur les valeurs les plus critiques, c'est-à-dire par exemple, si $m_L$ est codé entre -7 et + 7, sur les valeurs proches de 0. Cela permet de diviser environ par deux le taux d'erreur.

Selon l'invention, les indices de concurrence $m_L$ à $m_{L+L'}$ sont révisés à chaque instant de réception. Pour cela, les indices sont stockés dans des bascules $70_L$ à $70_{L+L'-1}$. Entre chacune de ces bascules s'intercale un module $71_{L+1}$ à $71_{L+L'}$ de révision de la concurrence, qui compare niveau à niveau les valeurs $s_k$ et $s'_k$ présentes sur les deux chemins concurrents, fournies par les modules de double remontée. Ce module 71 de révision est décrit plus en détail en relation avec la figure 8.

A chaque instant de réception, le décodeur fournit donc finalement les valeurs définitives $s_{L+L'}$ et $m_{L+L'}$.

La figure 7 est le schéma de principe d'un module 64 de remontée. Ce module comprend un multiplexeur $2^v$ vers 1 75, alimenté par les $2^v$ survivants $s_j$ au niveau k. Le multiplexeur 75 est piloté par la valeur $j_k$ issue du module de remontée précédent, et désigne le survivant à considérer sur le chemin optimal au niveau k + 1. Il transmet à un module 76 cette information $s_{jk}$ qui, combinée à $j_k$, fournit l'adresse $j_{k+1}$ du noeud de niveau suivant du chemin optimal.

Un module de révision 71 est représenté en figure 8. Au niveau k, l'indice de concurrence $m_k$, codé sur n-1 bits est l'une des entrées 81 d'un multiplexeur 2 vers 1 82. L'autre entrée 83 de ce multiplexeur est fournie par un module 84 qui fournit la plus petite des valeurs $m_k$ et $m_L$, $m_L$ étant l'indice de concurrence issu du module 69 (figure 5) de compression logarithmique.

Le multiplexeur 82 est piloté par la sortie d'un OU exclusif 85, qui compare les valeurs $s_k$ et $s'_k$ des deux chemins concurrents au niveau k. Si ces valeurs sont identiques, la valeur $m_k$ est conservée. Sinon, $m_k$ est remplacée par la plus petite des valeurs $m_k$ et $m_L$.

L'obtention de $m_L$ peut également se faire de la façon suivante, plus favorable, d'un point de vue encombrement de circuit, pour les longueurs de contrainte élevées. En se référant à la figure 6, la mémoire FIFO 66 contenant les indices de concurrence est remplacée par une autre mémoire, représentée en figure 9. Cette mémoire 91, également de type FIFO, est de taille L × 2n, pour "transporter" les grandeurs reçues X' et Y' jusqu'au niveau i=L.

Il est alors possible, en fin du premier treillis, de recalculer les métriques cumulées et la concurrence modifiée $m_L$, dans un module de calcul 92. Cette variante évite le calcul des $2^v - 1$ indices de concurrence qui ne sont pas exploités à la sortie de la mémoire 66 (figure 6), dans le procédé précédemment décrit.

Les valeurs des indices de concurrence $\Delta M_0$ à $\Delta M_{2^v-1}$ sont transmises ensuite au multiplexeur $2^v$ vers 1 68.

Il est clair que le procédé de l'invention peut également s'appliquer aux codes systématiques, pseudo-systématiques ou séparables. En effet, la fiabilité de la décision binaire peut être attribuée aux symboles X et Y reconstruits suivant les mêmes opérations combinatoires que celles effectuées lors du codage.

Dans ce cas, en se référant à la figure 4,la condition de révision du contenu du registre 44 ne porte plus sur la comparaison des bits $a_k$, représentés par $s_k$, des deux chemins concurrents 48 et 49 dans le second treillis 41, mais sur la comparaison des bits $X_k$ ou $Y_k$ reconstitués à chaque niveau k.

Le procédé de l'invention est quasi-optimal, le terme optimal désignant ici un algorithme de pondération délivrant en sortie du décodeur des décisions dont les pondérations suivent une loi de distribution gaussienne.

En effet, on obtient un taux d'erreur binaire identique en sortie d'une chaîne de deux décodeurs dont le premier mettrait en oeuvre un algorithme de pondération optimal, et en sortie d'un seul décodeur, identique au second décodeur de la chaîne précédente, prélevant ses échantillons sur un canal gaussien dont le taux d'erreur binaire est égal au taux d'erreur binaire observé à la sortie du premier décodeur de la chaîne.

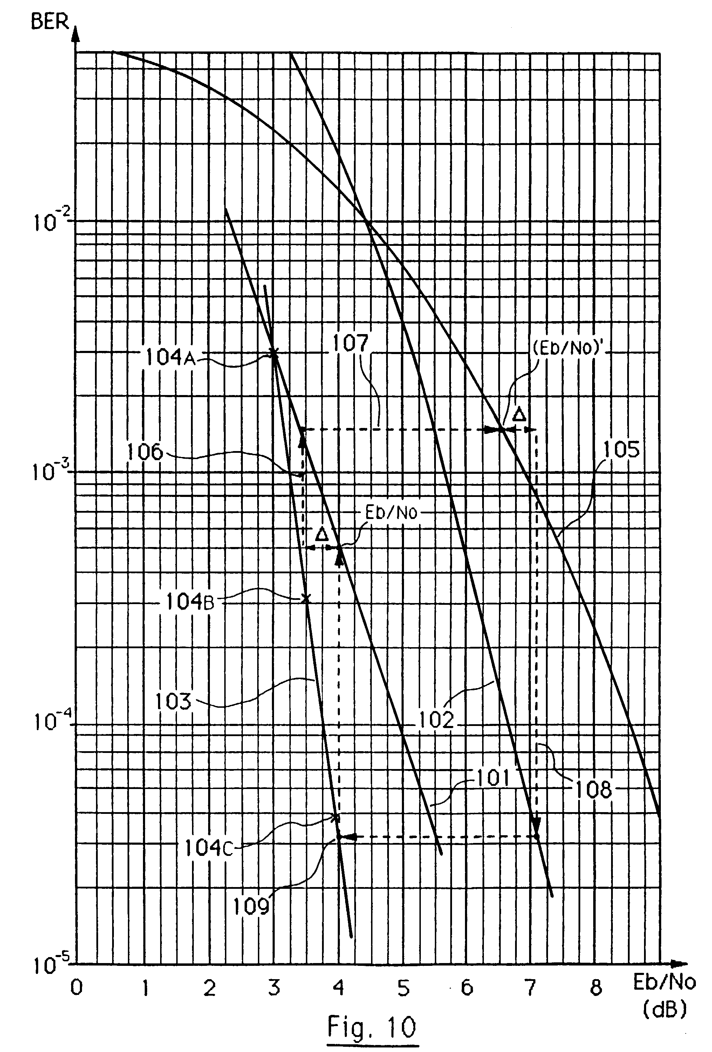

La figure 10 illustre les performances du procédé de l'invention, dans le cas d'une concaténation d'un code de longueur de contrainte 4 et de rendement 4/7, dont la caractéristique de taux d'erreur est donnée par la courbe 101, le décodeur travaillant en décisions fines, et d'un code de longueur de contrainte 2 et de rendement 7/8. La courbe 102 est la caractéristique de taux d'erreur de ce second code, le décodeur travaillant également en décisions fines.

La courbe 103 représente le taux d'erreur théorique en sortie de chaîne. Elle est obtenue de la manière suivante

- à un rapport signal à bruit $E_b/N_0$ donné, $E_b$ étant l'énergie reçue par bit utile et $N_0$ la densité spectrale monolatérale de bruit, on relève (106) le taux d'erreur donné par la courbe 101 à l'abscisse $E_b/N_0 - \Delta$, où $\Delta = 10.\log_{10}(8/7)$;
- à ce taux d'erreur correspond (107) sur la courbe 105 (transmission non codée) un rapport signal à bruit $(E_b/N_0)$' auquel on ajoute $\Delta = 10.\log_{10}(8/7)$, afin d'obtenir le rapport signal à bruit pour lequel la courbe 102 fournit (108) le taux d'erreur recherché. On obtient ainsi le point 109 de la courbe théorique 103.

Les croix $104_A$, $104_B$ et $104_C$ représentent les résultats obtenus par simulation d'un décodeur utilisant le procédé de décodage de l'invention. L'écart entre ces résultats et la courbe optimale 103 n'est pas mesurable. Le procédé de l'invention est donc, à tout le moins, quasi-optimal.

Ce procédé de décodage représente, en terme de circuiterie, une complexité environ double de celle d'un décodeur de Viterbi à décisions binaires, dans le cas où L'=L/2. Il peut donc aisément être implanté sur silicium.

Par ailleurs, du fait de la structure série, et éventuellement pipe-line, du décodeur complet représenté en figures 4 et 6, les étapes de pondération et de révision ne pénalisent pas l'étape de décision selon l'algorithme de Viterbi, pour ce qui concerne sa rapidité de traitement de données.

## Revendications

1. Procédé de décodage à maximum de vraisemblance d'une séquence d'échantillons reçus R(t), correspondant au codage convolutif d'une séquence d'éléments numériques source a(t),

   du type associant à chacun desdits échantillons reçus R(t) une estimation s(t) de l'élément numérique source correspondant a(t) et un coefficient de pondération m(t) représentatif de la fiabilité de ladite estimation s(t), ladite estimation s(t) prenant en compte les valeurs d'une première série de L échantillons reçus, comprenant ledit échantillon reçu R(t) correspondant audit élément numérique source a(t) et les L-1 échantillons reçus suivants R(t+1),..., R(t+L-1), L étant supérieur ou égal à 2, caractérisé en ce que ladite pondération m(t) prend en compte les valeurs d'une seconde série de N échantillons reçus, comprenant ledit échantillon reçu R(t) correspondant audit élément numérique source a(t) et les N-1 échantillons reçus suivants R(t+1),..., R(t+L-1),..., R(t+N-1), N étant strictement supérieur à L.

**2.** Procédé selon la revendication 1, du type comprenant une étape d'estimation de la valeur s(t) de chacun desdits éléments numériques source a(t) et une étape de pondération de l'estimation s(t),

ladite étape d'estimation prenant en compte, pour l'estimation de la valeur d'un élément numérique source s(t), les valeurs d'une série d'échantillons reçus, comprenant l'échantillon reçu R(t) correspondant audit élément numérique source a(t) et au moins un des échantillons reçus suivants R(t+1),..., R(t+L-1),
ladite étape de pondération consistant à associer, à chacune desdites estimations s(t), un coefficient de pondération m(t) représentatif de la fiabilité de ladite estimation,
caractérisé en ce qu'il comprend de plus une étape de révision dudit coefficient de pondération consistant à réviser, à chaque instant de réception t, chacun des coefficients de pondération m(t-N) à m(t-L-1), correspondant aux N-L dernières valeurs estimées s(t-N) à s(t-L-1), en fonction de l'échantillon reçu R(t).

**3.** Procédé selon la revendication 2, du type consistant à décider, à l'aide d'un algorithme décisionnel du type de l'algorithme de Viterbi, d'une estimation s(t) de la valeur de chacun desdits éléments numériques source a(t),

ledit algorithme décisionnel définissant un premier treillis $T(2^v, L)$ des états possibles du codage, comprenant un ensemble de noeuds, organisé en L colonnes, ou niveaux de profondeur, de $2^v$ noeuds,
L étant le nombre d'échantillons reçus R(t-L-1),..., R(t) pris en compte pour l'estimation s(t) de la valeur d'un desdits éléments numériques source a(t), et $2^v$ étant le nombre d'états possibles du code convolutif à un instant donné, v étant la longueur de contrainte du code mis en oeuvre au codage,
chacun desdits noeuds d'un niveau de profondeur i donné correspondant à un instant de réception donné, et étant relié à deux noeuds du niveau de profondeur précédent i-1, correspondant à l'instant de réception précédent, par l'intermédiaire de deux chemins, chaque chemin correspondant à une transition possible selon ledit code convolutif,

ladite étape d'estimation consistant à :

- déterminer, pour chaque noeud dudit premier treillis, le chemin y aboutissant le plus probable, ou chemin survivant, et éliminer dudit premier treillis le chemin concurrent dudit chemin survivant,

le chemin survivant étant celui présentant la distance cumulée $M^0$ ou $M^1$ la plus faible ;

- remonter dans ledit premier treillis le chemin optimal, en partant du noeud présentant la métrique cumulée la plus faible sur le premier niveau de profondeur, correspondant au dernier échantillon R(t) reçu, et en suivant à chaque niveau le chemin survivant associé au noeud atteint,
- associer à l'estimation s(t-L) correspondant au décodage de l'échantillon reçu R(t-L), la valeur du noeud terminal dudit chemin optimal,

et ladite étape de pondération consistant à associer à ladite estimation s(t-L) un coefficient de pondération m(t-L), représentatif de la fiabilité de ladite estimation s(t-L), ledit coefficient de pondération étant obtenu par analyse des métriques cumulées $M^0$ et $M^1$ associées à chacun des noeuds dudit chemin optimal,
ledit procédé étant caractérisé en ce qu'il comprend une étape de révision desdits coefficients de pondération, consistant à, à chaque instant de réception t :

- mémoriser le coefficient de pondération m(t-L) associé à ladite estimation s(t-L);
- définir un second treillis $T'(2^v, L')$ des états possibles du codage, où L'=N-L, consécutif audit premier treillis $T(2^v, L)$, correspondant aux instants de réception compris entre t-L-1 et t-L-L' ;
- remonter, dans ledit second treillis, les deux chemins concurrents correspondant aux deux chemins issus dudit noeud terminal du chemin optimal du premier treillis ;
- réviser les valeurs de chacun des coefficients de pondération m(t-L-1) à m(t-N) associé respectivement à chacune des estimations s(t-L-1) à s(t-N) des valeurs des échantillons numériques reçus entre les instants t-L-1 et t-N, en fonction d'une comparaison niveau à niveau des valeurs $s_k$ et $s'_k$ correspondant à ces échantillons numériques reçus, sur les deux chemins concurrents.

**4.** Procédé selon la revendication 3, caractérisé en ce que ledit coefficient de pondération m(t-L) déterminé lors de ladite étape de pondération est égal à la valeur absolue $\Delta M_{t-L}$ de la différence entre les deux métriques $M^0_{t-L}$ et $M^1_{t-L}$ associées audit noeud terminal dudit chemin optimal, encore appelée indice de concurrence, lesdites métriques $M^0_{t-L}$ et $M^1_{t-L}$ étant le cumul des distances $L^0$ ou $L^1$ calculées pour chaque noeud dudit chemin optimal, lesdites distances représentant l'écart entre le symbole reçu et les symboles correspondant aux deux transitions possibles pour atteindre ce noeud.

5. Procédé selon la revendication 4, caractérisé en ce que ladite étape de révision réalise, à chaque instant de réception t et pour chacun des niveaux k dudit second treillis, une comparaison des valeurs $s_k$ et $s'_k$ correspondant à l'échantillon reçu R(t-L-k) sur chacun des deux chemins concurrents, ledit indice de concurrence $m_k$ étant révisé à la baisse si ces valeurs $s_k$ et $s'_k$ sont différentes.

6. Procédé selon la revendication 5, caractérisé en ce que, lorsque lesdites valeurs $s_k$ et $s'_k$ correspondant à l'échantillon reçu R(t-L-k) sur chacun des deux chemins concurrents sont différentes, ledit indice de concurrence $m_k$ est pris égal à la plus petite des valeurs $m_k$ et $m_L$, $m_L$ étant l'indice de concurrence associé à l'estimation s(t-L), origine desdits chemins concurrents, déterminé lors de ladite étape de pondération.

7. Procédé selon la revendication 6, caractérisé en ce que ledit indice de concurrence $m_L$ est recalculé, à chaque instant de réception t, en fonction des échantillons reçus mémorisés R(t-L) à R(t).

8. Procédé selon l'une quelconque des revendications 3 à 6, caractérisé en ce qu'un coefficient de pondération provisoire ΔM est associé à chacun desdits noeuds dudit premier treillis, chacun desdits coefficients de pondération ΔM étant mis à jour à chaque instant de réception t, en fonction de l'échantillon reçu R(t).

9. Procédé selon l'une quelconque des revendications 4 à 9, caractérisé en ce que ladite étape de révision comprend une étape de compression logarithmique dudit indice de concurrence $m_{t-L}$, avant de le mémoriser.

10. Procédé selon l'une quelconque des revendications 3 à 9, caractérisé en ce que la profondeur L' dudit second treillis est sensiblement égale à la moitié de la profondeur L dudit premier treillis.

11. Procédé selon l'une quelconque des revendications 1 à 10, caractérisé en ce que lesdits échantillons reçus R(t) comprennent, à au moins certains instants t, deux données codées distinctes X(t) et Y(t) correspondant audit élément numérique source a(t).

12. Décodeur d'une séquence d'échantillons reçus R(t), correspondant au codage convolutif d'une séquence d'éléments numériques source a(t), caractérisé en ce qu'il comprend :

   - des moyens de mémorisation d'un premier treillis de profondeur L et d'un second treillis de profondeur L', se comportant comme des registres à décalage niveau par niveau ;
   - des moyens de remontée d'un chemin optimal, dans ledit premier treillis, et des moyens de remontée de deux chemins concurrents dans ledit second treillis ;
   - des moyens de mémorisation de l'ensemble d'indices de concurrence associés à chacun des noeuds dudit premier treillis, de taille L x $2^v$ x μ, μ étant le nombre de bits utilisés pour le codage d'un indice de concurrence ;
   - un registre à décalage, pour la mémorisation de coefficients de pondération m(t-L-1) à m(t-L-L') ;
   - des moyens de révision desdits coefficients de pondération, en fonction desdits chemins concurrents remontés dans ledit second treillis.

13. Décodeur d'une séquence d'échantillons reçus R(t), correspondant au codage convolutif d'une séquence d'éléments numériques source a(t), caractérisé en ce qu'il comprend :

   - des moyens de mémorisation d'un premier treillis de profondeur L et d'un second treillis de profondeur L', se comportant comme des registres à décalage niveau par niveau ;
   - des moyens de remontée d'un chemin optimal, dans ledit premier treillis, et des moyens de remontée de deux chemins concurrents dans ledit second treillis ;
   - des moyens de mémorisation de l'ensemble des échantillons reçus R(t-L) à R(t), de taille L x n, n étant le nombre de bits utilisés pour le codage de la valeur d'un échantillon reçu ;
   - des moyens de calcul du coefficient de pondération m(t-L), à partir de l'ensemble des échantillons reçus R(t-L) à R(t) mémorisés ;
   - un registre à décalage, pour la mémorisation des coefficients de pondération m(t-L-1) à m(t-L-L') ;
   - des moyens de révision desdits coefficients de pondération, en fonction desdits chemins concurrents remontés dans ledit second treillis.

**14.** Décodeur selon l'une quelconque des revendications 12 ou 13, caractérisé en ce que ledit registre à décalage pour la mémorisation des coefficients de pondération est alimenté par l'indice de concurrence $m_{t-L}$ dudit noeud final dudit chemin optimal, transformé selon une loi logarithmique.

**Patentansprüche**

**1.** Dekodierungsverfahren mit maximaler Wahrscheinlichkeit einer empfangenen Folge von abgetasteten Daten R(t), die der faltenden Kodierung einer Ausgangsfolge digitaler Elemente a(t) entspricht,

von der Art, die jedem der empfangenen abgetasteten Daten R(t) eine Abschätzung s(t) des entsprechenden digitalen Ausgangselementes a(t) sowie einen für die Zuverlässigkeit der Abschätzung s(t) repräsentativen Wichtungskoeffizienten m(t) zuordnet,
wobei die Abschätzung s(t) die Werte einer ersten Reihe von L empfangenen abgetasteten Daten berücksichtigt, welche den empfangenen abgetasteten Wert R(t) enthält, der dem digitalen Ausgangselement a(t) sowie den folgenden L empfangenen abgetasteten Werten R(t+1), ..., R(t+L-1), mit L größer oder gleich 2, entspricht, dadurch gekennzeichnet, daß die Wichtung m(t) die Werte einer zweiten Reihe von N empfangenen abgetasteten Werten berücksichtigt, welche den empfangenen abgetasteten Wert R(t) umfaßt, der dem digitalen Ausgangselement a(t) sowie den folgenden N-1 empfangenen abgetasteten Werten R(t+1), ..., R(t+L-1), ... R(t+N-1), mit N streng größer L, entspricht.

**2.** Verfahren gemäß Anspruch 1, von der Art, die eine Abschätzungsstufe des Wertes s(t) eines jeden dieser digitalen Ausgangselemente a(t) sowie eine Wichtungsstufe der Abschätzung s(t) umfaßt,

wobei die Abschätzungsstufe für die Abschätzung des Wertes eines digitalen Ausgangselements s(t) die Werte einer Reihe empfangener abgetasteter Daten berücksichtigt, welche den empfangenen abgetasteten Wert R(t) umfassen, der dem digitalen Ausgangselement a(t) und mindestens einem der folgenden empfangenen abgetasteten Werte R(t+1), ..., R(t+L-1) entspricht,
wobei die Wichtungsstufe darin besteht, daß jedem der abgeschätzten Werte s(t) ein für die Zuverlässigkeit dieser Abschätzung repräsentativer Wichtungskoeffizient m(t) zugeordnet wird,
dadurch gekennzeichnet, daß es darüber hinaus eine Revisionsstufe des Wichtungskoeffizienten umfaßt, welche darin besteht, daß zu jedem Empfangszeitpunkt t jeder der Wichtungskoeffizienten m(t-N) bis m(t-L-1), welcher den N-L letzten abgeschätzten Werten s(t-N) bis s(t-L-1) entspricht, als Funktion des empfangenen abgetasteten Wertes R(t) revidiert wird.

**3.** Verfahren gemäß Anspruch 2, von der Art, die mittels eines Entscheidungsalgorithmus von der Art des Viterbialgorithmus über eine Abschätzung s(t) des Wertes eines jeden der digitalen Ausgangselemente a(t) entscheidet,

wobei der Entscheidungsalgorithmus ein erstes Gitter T($2^v$. L) der möglichen Kodierungszustände definiert, welches eine Vielfalt von Knoten umfaßt, die in L Spalten oder Tiefenebenen zu je $2^v$ Knoten angeordnet sind,
wobei L die Zahl der empfangenen abgetasteten Daten R(t-L-1), ..., R(t), welche bei der Abschätzung s(t) des Wertes eines der digitalen Ausgangselemente a(t) berücksichtigt werden und $2^v$ die Zahl der möglichen Zustände des faltenden Codes zu einem gegebenen Zeitpunkt ist; dabei ist v die Bedingungslänge des beim kodieren angewandten Codes,
wobei jeder Knoten einer gegebenen Tiefenebene i einem gegebenen Empfangszeitpunkt entspricht und mit zwei Knoten der vorhergehenden Tiefenebene i-1, die dem vorausgegangenen Empfangszeitpunkt entspricht, über zwei Pfade in Verbindung steht, welche jeweils einem möglichen Übergang gemäß dem faltenden Code entsprechen, wobei die Abschätzungsstufe im folgenden besteht:

- Feststellung, für jeden Knoten des ersten Gitters, des mit größter Wahrscheinlichkeit dort ankommenden Pfades oder überlebenden Pfades und Eliminierung aus diesem ersten Gitter des mit dem überlebenden Pfad in Konkurrenz stehenden Pfades,

wobei der überlebende Pfad derjenige ist, der die geringste kumulierte Entfernung $M^0$ oder $M^1$ aufweist:

- ausgehend vom Knoten, der die geringste kumulierte Metrik über die erste Tiefenebene aufweist, Verfolgung in aufsteigender Richtung des optimalen Pfades im ersten Gitter, der dem letzten empfangenen abgetasteten Wert R(t) entspricht und wobei auf jeder Ebene der überlebende Pfad verfolgt wird, der dem erreichten Knoten zugeordnet ist,
- Zuordnung des Wertes des Endknotens dieses optimalen Pfades zur Abschätzung s(t-L), welche der Dekodierung des empfangenen abgetasteten Wertes R(t-L) entspricht,

sowie der Wichtungsstufe, die darin besteht, daß der Abschätzung s(t-L) ein für die Zuverlässigkeit dieser Abschätzung s(t-L) repräsentativer Wichtungskoeffizient m(t-L) zugeordnet wird, wobei dieser Wichtungskoeffizient durch Analyse der kumulierten Metriken $M^0$ und $M^1$ erhalten wird, die jedem Knoten des optimalen Pfades zugeordnet ist,
wobei das Verfahren dadurch gekennzeichnet ist, daß es eine Revisionsstufe der Wichtungskoeffizienten umfaßt, die zu jedem Empfangszeitpunkt t im folgenden besteht:

- Speichern des der Abschätzung s(t-L) zugeordneten Wichtungskoeffizienten s(t-L);
- Definition eines zweiten Gitters T'($2^v$, 1') der möglichen Kodierungszustände, wobei L' = N-L, das auf das erste Gitter T($2^v$, L) folgt. und den Empfängszeitpunkten entspricht, die sich zwischen t-L-1 und t-L-L' befinden;
- Verfolgen der zwei miteinander konkurrierenden Pfade in aufsteigender Richtung im zweiten Gitter, die den zwei Pfaden entsprechen, welche dem Endknoten des optimalen Pfades des ersten Gitters entspringen;
- Revidieren der Werte eines jeden der Wichtungskoeffizienten m(t-L-1) bis m(t-N), die jeweils den Abschätzungen s(t-L-1) bis s(t-N) der zwischen den Zeitpunkten t-L-1 und t-N empfangenen Werte abgetasteter digitaler Daten zugeordnet sind, als Funktion eines Vergleichs von Ebene zu Ebene der Werte $s_k$ und $s'_k$, welche diesen auf den zwei konkurrierenden Pfaden empfangenen digitalen abgetasteten Daten entsprechen.

4. Verfahren gemäß Anspruch 3, dadurch gekennzeichnet, daß der bei der Wichtungsstufe festgestellte Wichtungskoeffizient m(t-L) dem auch Konkurrenzindex genannten Absolutwert $\Delta M_{t-L}$ der Differenz zwischen den zwei Metriken $M^0_{t-L}$ und $M^1_{t-L}$ gleicht, welche dem Endknoten des optimalen Pfades zugeordnet sind,

wobei die Metriken $M^0_{t-L}$ und $M^1_{t-L}$ die Kumulierung der Entfernungen $L^0$ und $L^1$ sind, die für jeden Knoten des optimalen Pfades berechnet werden,
wobei diese Entfernungen den Abstand zwischen dem empfangenen Symbol und den Symbolen darstellen, welche den zwei möglichen Übergängen, um diesen Knoten zu erreichen, entsprechen.

5. Verfahren gemäß Anspruch 4. dadurch gekennzeichnet, daß die Revisionsstufe zu jedem Empfangszeitpunkt t und für jede Ebene k des zweiten Gitters, einen Vergleich der Werte $s_k$ und $s'_k$ ausführt, die dem auf jedem der konkurrierenden Pfade empfangenen abgetasteten Wert R(t-L-k) entsprechen, wobei der Konkurrenzindex $m_k$ nach unten revidiert wird. wenn die Werte $s_k$ und $s'_k$ verschieden sind.

6. Verfahren gemäß Anspruch 5, dadurch gekennzeichnet, daß wenn die Werte $s_k$ und $s'_k$, die dem über jeden der konkurrierenden Pfade empfangenen abgetasteten Wert R(t-L-k) entsprechen, verschieden sind, der Konkurrenzindex $m_k$ gleich dem kleinsten der Werte $m_k$ und $m_L$ genommen wird, wobei $m_L$ der der Abschätzung s(t-L) zugeordnete Konkurrenzindex und der Ausgangspunkt der konkurrierenden Pfade ist, die bei der Wichtungsstufe festgelegt wurden.

7. Verfahren gemäß Anspruch 6, dadurch gekennzeichnet, daß der Konkurrenzindex $m_L$ zu jedem Empfangszeitpunkt t neu berechnet wird, als Funktion der gespeicherten empfangenen abgetasteten Werte R(t-L) bis R(t).

8. Verfahren gemäß einem der Ansprüche 3 bis 6. dadurch gekennzeichnet, daß jedem Knoten des ersten Gitters ein provisorischer Wichtungskoeffizient $\Delta M$ zugeordnet wird, wobei jeder dieser Wichtungskoeffizienten $\Delta M$ zu jedem Empfangszeitpunkt als Funktion des empfangenen abgetasteten Wertes R(t) aktualisiert wird.

9. Verfahren gemäß einem der Ansprüche 4 bis 9, dadurch gekennzeichnet, daß die Revisionsstufe einen logarithmischen Kompressionsschritt des Konkurrenzindex $m_{t-L}$ vor dessen Speicherung umfaßt.

10. Verfahren gemäß einem der Ansprüche 3 bis 9, dadurch gekennzeichnet, daß die Tiefe L' des zweiten Gitters in etwa der Hälfte der Tiefe des ersten Gitters gleicht.

11. Verfahren gemäß einem der Ansprüche 1 bis 10, dadurch gekennzeichnet, daß die empfangenen abgetasteten Daten R(t) zu mindestens einigen Empfangszeitpunkten t zwei verschiedene kodierte Daten X(t) und Y(t) umfassen, welche dem digitalen Ausgangselement a(t) entsprechen.

12. Decoder einer Folge empfangener abgetasteter Daten R(t), die der faltenden Kodierung einer Folge digitaler Ausgangsdaten a(t) entspricht, dadurch gekennzeichnet, daß es folgendes umfaßt:

- Mittel zum Speichern eines ersten Tiefengitters L und eines zweiten Tiefengitters L', die sich als Ebene-zu-Ebene Verschieberegister verhalten;
- Mittel zum Verfolgen eines optimalen Pfades im ersten Gitter sowie Mittel zum Verfolgen zweier konkurrierender Pfade im zweiten Gitter, jeweils in aufsteigender Richtung:
- Mittel zum Speichern der Gesamtheit der Konkurrenzindizes, die jedem der Knoten des ersten Gitters zugeordnet sind, mit der Größe $L \times 2^v \times \mu$, wobei $\mu$ die Zahl der Bits ist, die für das Kodieren eines Konkurrenzindex verwendet werden;
- ein Verschieberegister zum Speichern der Wichtungskoeffizienten m(t-L-1) bis m(t-L-L'):
- Mittel zum Revidieren dieser Wichtungskoeffizienten als Funktion der miteinander konkurrierenden Pfade, die im zweiten Gitter in aufsteigender Richtung verfolgt wurden.

13. Decoder einer Folge empfangener abgetasteter Daten R(t), die der faltenden Kodierung einer Folge digitaler Ausgangsdaten a(t) entspricht, dadurch gekennzeichnet, daß er folgendes umfaßt:

- Mittel zum Speichern eines ersten Tiefengitters L und eines zweiten Tiefengitters L', die sich als Ebene-zu-Ebene Verschieberegister verhalten;
- Mittel, um einen optimalen Pfad im ersten Gitter sowie Mittel, um zwei miteinander konkurrierende Pfade im zweiten Gitter jeweils in aufsteigender Richtung zu verfolgen;
- Mittel zum Speichern der Gesamtheit der empfangenen Daten R(t-L) bis R(t), mit der Größe L x n, wobei n die Zahl der Bits ist, die für das Kodieren eines empfangenen abgetasteten Wertes verwendet werden;
- Mittel zum Berechnen des Wichtungskoeffizienten m(t-L), ausgehend von der Gesamtheit der gespeicherten empfangenen abgetasteten Daten R(t-L) bis R(t);
- ein Verschieberegister zum Speichern der Wichtungskoeffizienten m(t-L-1) bis m(t-L-L'):
- Mittel zum Revidieren dieser Wichtungskoeffizienten als Funktion der im zweiten Gitter hinaufgelaufenen miteinander konkurrierende Pfade.

14. Decoder gemäß einem der Ansprüche 12 oder 13, dadurch gekennzeichnet, daß das Verschieberegister zum Speichern der Wichtungskoeffizienten durch den nach einem logarithmischen Gesetz transformierten Konkurrenzindex $m_{t-L}$ des Endknotens des optimalen Pfads gespeist wird.

## Claims

1. Method for maximum likelihood decoding of a sequence of received samples R(t) corresponding to the convolutional coding of a sequence of digital source elements a(t),

    of the type associating, with each of the said received samples R(t), an estimation s(t) of the corresponding digital source element a(t) and a weighting coefficient m(t) representing the reliability of said estimation s(t), the said estimation s(t) taking account of the values of a first series of L received samples, comprising the said received sample R(t) corresponding to the said digital source element a(t) and the following L-1 received samples R(t+1), ..., R(t+L-1), L being greater than or equal to 2, characterised in that the said weighting m(t) takes account of the values of a second series of N received samples, comprising the said received sample R(t) corresponding to the said digital source element a(t) and the following N-1 received samples R(t+1),..., R(t+L-1),..., R(t+N-1), N being strictly greater than L.

2. Method according to claim 1, of the type comprising a step of estimating the value s(t) of each of the said digital source elements a(t) and a step of weighting the estimation s(t),

    the said estimation step taking account, for the estimation of the value of a digital source element s(t), of the values of a series of received samples, comprising the received sample R(t) corresponding to the said digital source element a(t) and at least one of the following received samples R(t+1),... R(t+L-1), the said weighting step consisting of associating, with each of the said estimations s(t), a weighting coefficient m(t) representing the reliability of the said estimation, characterised in that it further comprises a step for the revision of the said weighting coefficient consisting of a revision, at each instant of reception t, of each of the weighting coefficients m(t-N) to m(t-L-1), corresponding to the N-L last estimated values s(t-N) to s(t-L-1) as a function of the received sample R(t).

3. Method according to claim 2, of the type consisting of deciding, by means of a decision algorithm of the Viterbi algorithm type, on an estimation s(t) of the value of each of the said digital source elements a(t),

the said decision algorithm defining a first trellis $T(2^v, L)$ of the possible states of the coding, comprising a set of nodes, organized in L columns, or depth levels, of $2^v$ nodes,
L being the number of received samples R(t-L-1),..., R(t) taken into account for the estimation s(t) of the value of one of the said digital source elements a(t), and $2^v$ being the number of possible states of the convolutional code at a given instant, v being the constraint length of the code used for the coding, each of the said nodes of a given depth level i corresponding to a given instant of reception and being connected to two nodes of the preceding depth level i-1, corresponding to the preceding instant of reception, by means of two paths, each path corresponding to a possible transition according to said convolutional code,
the said estimation step consisting in:

- determining, for each node of the said first trellis, the most probable path, or survivor path, ending there, and eliminating, from the said first trellis, the path concurrent with the said survivor path, the survivor path being the one having the smallest cumulated distance $M^0$ or $M^1$,
- tracing back the optimal path in the said first trellis, starting from the node having the smallest cumulated metric on the first depth level, corresponding to the last received sample R(t), and following, at each level, the survivor path associated with the node reached;
- associating, with the estimation s(t-L) corresponding to the decoding of the received sample R(t-L), the value of the terminal node of the said optimal path,

and the said weighting step consisting of associating, with the said estimation s(t-L), a weighting coefficient m(t-L), representing the reliability of the said estimation s(t-L), the said weighting coefficient being obtained by analysis of the cumulated metrics $M^0$ and $M^1$ associated with each of the nodes of the said optimal path, the said method being characterised in that it comprises a step for the revision of the said weighting coefficients consisting, at each instant of reception t, in:

- memorising the weighting coefficient m(t-L) associated with the said estimation s(t-L);
- defining a second trellis $T'(2^v, L')$ of the possible states of the coding, where L'=N-L, consecutive to the said first trellis $T(2^v, L)$, corresponding to the instants of reception between t-L-1 and t-L-L';
- tracing back, in the said second trellis, the two concurrent paths corresponding to the two paths coming from the said terminal node of the optimal path of the first trellis,
- revising the values of each of the weighting coefficients m(t-L-1) to m(t-N) associated respectively with each of the estimations s(t-L-1) to s(t-N) of the values of the digital samples received between the instants t-L-1 and t-N, as a function of a level-by-level comparison of the values $s_k$ and $s'_k$ corresponding to these digital samples received on the two concurrent paths.

4. Method according to claim 3, characterised in that the said weighting coefficient m(t-L) determined during the said weighting step is equal to the absolute value $\Delta M_{t-L}$ of the difference between the two metrics $M^0_{t-L}$ and $M^1_{t-L}$ associated with the said terminal node of the said optimal path, also called a concurrence index, the said metrics $M^0_{t-L}$ and $M^1_{t-L}$ being the total of the distances $L^0$ and $L^1$ computed for each node of the said optimal path, the said distances representing the difference between the received symbol and the symbols corresponding to the two transitions possible in order to reach this node.

5. Method according to claim 4, characterised in that the said revision step carries out, at each instant of reception t and for each of the levels k of the said second trellis, a comparison of the values $s_k$ and $s'_k$ corresponding to the sample R(t-L-k) received on each of the two concurrent paths, the said index of concurrence $m_k$ being revised downwards if these values $s_k$ and $s'_k$ are different.

6. Method according to claim 5, characterised in that, when the said values $s_k$ and $s'_k$ corresponding to the sample R(t-L-k) received on each of the two concurrent paths are different, the said index of concurrence $m_k$ is taken to be equal to the smallest of the values $m_k$ and $m_L$, $m_L$ being the index of concurrence associated with the estimation s(t-L), the starting point of the said concurrent paths, determined during the said weighting step.

7. Method according to claim 6, characterised in that the said index of concurrence $m_L$ is recomputed, at each instant of reception t, as a function of the memorized received samples R(t-L) to R(t).

8. Method according to any one of claims 3 to 6, characterised in that a provisional weighting coefficient $\Delta M$ is associated with each of the said nodes of the said first trellis, each of the said weighting coefficients $\Delta M$ being updated at each instant of reception t as a function of the received sample R(t).

9. Method according to any one of claims 4 to 9, characterised in that the said revision step comprises a step for the logarithmic compression of the said index of concurrence $m_{t-L}$, before it is memorized.

10. Method according to any one of claims 3 to 9, characterised in that the depth L' of the said second trellis is substantially equal to half the depth L of the said first trellis.

11. Method according to any one of claims 1 to 10, characterised in that the said received samples R(t) comprise, at least at certain instants t, two distinct coded data items X(t) and Y(t) corresponding to the said digital source element a(t).

12. Decoder of a sequence of received samples R(t), corresponding to the convolutional coding of a sequence of digital source elements a(t), characterised in that it comprises:

   - means for memorizing a first trellis of depth L and a second trellis of depth L', behaving like level-by-level shift registers;
   - means for tracing back an optimal path in the said first trellis, and means for tracing back two concurrent paths in the said second trellis;
   - means for memorizing the set of concurrence indices associated with each of the nodes of the said first trellis, of size $L \times 2^v \times \mu$, $\mu$ being the number of bits used for the coding of a concurrence index;
   - a shift register for memorizing the weighting coefficients m(t-L-1) to m(t-L-L');
   - means for the revision of the said weighting coefficients, as a function of the said two concurrent paths traced back in the said second trellis.

13. Decoder of a sequence of received samples R(t), corresponding to the convolutional coding of a sequence of digital source elements a(t), characterised in that it comprises:

   - means for memorizing a first trellis of depth L and a second trellis of depth L', behaving like level-by-level shift registers;
   - means for tracing back an optimal path in the said first trellis, and means for tracing back two concurrent paths in the said second trellis;
   - means for memorizing the set of received samples R(t-L) to R(t), of size $L \times n$, n being the number of bits used for the coding of the value of a received sample;
   - means for computing the weighting coefficient m(t-L) on the basis of the set of memorized received samples R(t-L) to R(t);
   - a shift register for memorizing the weighting coefficients m(t-L-1) to m(t-L-L');
   - means for the revision of the said weighting coefficients, as a function of the said concurrent paths traced back in the said second trellis.

14. Decoder according to either claim 12 or 13, characterised in that the said shift register for memorizing the weighting coefficients is supplied by the concurrence index $m_{t-L}$ of the said final node of the said optimal path, converted according to a logarithmic relationship.

Fig. 1

Fig. 2

**Fig. 3**

**Fig. 4**

Fig. 5

Fig. 7

Fig. 6

Sk   S'k                    81          82

mk ──►│n-1                          83                ─ mk
                                                     n-1

                          84

           n-1
      mL                                        85

Fig. 8

                91                                    92

X' ──►│n  ⟩ ⟩ ------ ⟩ ────────►│        $\Delta M_0$
                                              $\mu$

Y' ──►│n  ⟩ ⟩ ------ ⟩ ────────►│        $\Delta M_{2^y-1}$

Fig. 9

Fig. 10